# EUROPÄISCHE PATENTSCHRIFT

(11) **EP 2 304 818 B1**
(45) Veröffentlichungstag und Bekanntmachung des Hinweises auf die Patenterteilung: **30.05.2012**
(21) Anmeldenummer: 09780666.5
(22) Anmeldetag: 15.07.2009
(51) Int. Cl.: H01L 35/32, H01L 35/34

(54) **THERMOELEKTRISCHES BAUELEMENT UND VERFAHREN ZU SEINER HERSTELLUNG**
THERMOELECTRIC COMPONENT AND METHOD FOR THE PRODUCTION THEREOF
COMPOSANT THERMOÉLECTRIQUE ET SON PROCÉDÉ DE PRODUCTION

(30) Priorität: 16.07.2008 DE 102008040472
(43) Veröffentlichungstag der Anmeldung: 06.04.2011
(73) Patentinhaber: Leibniz-Institut für Festkörper- und Werkstoffforschung E.V., 01069 Dresden (DE)
(72) Erfinder: DIENEL, Thomas, 8049 Zürich (CH); SCHUMANN, Joachim, 01309 Dresden (DE); RASTELLI, Armando, 01159 Dresden (DE); SCHMIDT, Oliver G., 01219 Dresden (DE)
(74) Vertreter: Rauschenbach, Marion
(86) Internationale Anmeldenummer: PCT/EP2009/059103
(87) Internationale Veröffentlichungsnummer: WO 2010/007110

(56) Entgegenhaltungen:
- DE-A1- 10 159 415
- DE-A1- 10 231 445
- JP-A- 2004 104 041
- JP-A- 2004 241 657
- US-A- 5 286 304

## Beschreibung

Die Erfindung bezieht sich auf die Gebiete der Physik und der Werkstoffwissenschaften und betrifft ein thermoelektrisches Bauelement, wie es beispielsweise als Sensor oder als Energiekonverter oder als thermionischer Kühler zum Einsatz kommen kann, und ein Verfahren zu seiner Herstellung.

Thermische Energie in elektrische Energie zu wandeln, ist ein seit langem bekannter Vorgang. In klassischen Kraftwerken wird dabei aus thermischer Energie Bewegungsenergie generiert, die dann wiederum in elektrische Energie umgewandelt wird. Um diese Prozesse mit hoher Effizienz betreiben zu können, ist eine große Menge an thermischer Energie notwendig, die sich durch einen Temperaturunterschied von mehreren 100 K der damit beladenen Medien oder Körper gegenüber der Umgebungstemperatur auszeichnet.

Thermische Energie bei geringen Temperaturunterschieden ist mit der genannten Prozessabfolge in effektiver Weise nicht in elektrische Energie zu wandeln. Um derartige thermische Energie - die so genannte Niedrigtemperaturenergie - in elektrische Energie zu wandeln, lassen sich thermoelektrische Prozesse mit gutem Erfolg ausnutzen.

Bei einem thermoelektrischen Bauelement unter Ausnutzung des Peltier-Seebeck-Wirkprinzips resultiert das Anlegen eines Temperaturgradienten direkt in einen elektrischen Potentialunterschied. Die Wechselwirkung zwischen dem Temperatur- und dem Spannungsgradienten wird durch den Seebeck-Koeffizienten beschrieben. Ein einzelnes thermoelektrisches Grundelement kann allerdings nur eine sehr geringe elektrische Spannung oder nur einen sehr geringen elektrischen Strom erzeugen, was die Notwendigkeit begründet, kaskadenförmige Baugruppen zu realisieren.

Aus diesem Grunde finden thermoelektrische Prozesse neben dem Einsatz in der Leistungsgeneratorik, wo mittels großer Kaskaden das erforderliche Spannungsniveau erzeugt wird, bevorzugt auch in der Messtechnik Anwendung. Dort können die geringen elektrischen Spannungen als sensorische Signale für eine Bestimmung der Temperatur oder Temperaturdifferenz verwendet werden.

An einigen ausgewählten Beispielen sollen im Folgenden Vor- und Nachteile bestehender Lösungen genannt werden.
Aus der DE 101 12 383 A1 sind ein Thermoelement und ein daraus aufgebauter Thermogenerator bekannt, der aus einer Vielzahl von übereinander geschichteten Thermoelementen besteht. Die einzelnen Elemente bestehen jeweils aus einem quaderförmigen Trägerkörper aus formbeständigem dielektrischem Material. Zwei gegenüberliegende Seiten dieses Trägerkörpers sind mit unterschiedlichen Materialien aus der thermoelektrischen Spannungsreihe beschichtet. Auf einer dritten Seite stoßen die beiden Metallschichten zusammen und überlappen sich. Die sich berührenden Seiten der Thermoelemente in dem Stapel weisen die gleiche Metallbeschichtung auf und die dritte Seite liegt abwechselnd zu den Stapelaußenseiten frei.

Weitere thermoelektrische Elemente sind nach der DE 10 2006 005 596 A1, DE 102 31 445 A1, DE 40 22 690 A1 bekannt.

Nach der DE 10 2006 024 167 A1 ist ein Thermogenerator bekannt, der eine erste elektrische Spannungsquelle mit einem ersten Spannungsausgang und eine zweite elektrische Spannungsquelle mit einem zweiten Spannungsausgang aufweist. Dabei ist die erste elektrische Spannungsquelle aus einem ersten thermoelektrischen Element gebildet, und es ist ein dritter Spannungsausgang vorgesehen, der mit dem ersten Spannungsausgang und dem zweiten Spannungsausgang gekoppelt ist.

Weiterhin ist nach der DE 10 2006 015 492 A1 ein Thermogenerator bekannt, bei der der Thermogenerator aus einer Vielzahl an Thermoelementen auf einem Substrat als Hauptfunktionsebene besteht. Jedes Thermoelement weist einen heißen Thermokontakt und einen kalten Thermokontakt auf, wobei die Thermokontakte senkrecht zur Hauptfunktionsebene säulenartig aufgebaut sind.

Neben einem thermoelektrischen Bauelement unter Ausnutzung des Peltier-Seebeck-Wirkprinzips sind auch thermionische Bauelement bekannt, die eben das thermionische Wirkprinzip ausnutzen. Der grundsätzliche bekannte Aufbau eines thermionischen Bauelementes basiert auf der Ausnutzung der thermionischen Refrigeration - eine von der thermoelektrischen Refrigeration abweichendes Funktionsprinzip. Der Name stammt von der thermionischen Emission, bei der heiße Elektronen unter Überwindung der Austrittsarbeit eine Metalloberfläche verlassen können. Bekanntermaßen kühlt sich jedes stoffliche System ab, wenn man deren energiereichste Teilchen in kontinuierlicher Weise aus ihm entfernt. Bei einer Kühlvorrichtung erzielt der von einer Spannung initiierte Elektronenstrom von der kälteren Seite zur wärmeren Seite eine weitere Abkühlung der kälteren Seite. Die Effektivität dieses Kühleffektes wird im Wesentlichen durch die geeignet auszuwählende Austrittsarbeit der Elektrode bestimmt: je niedriger die Austrittsarbeit ist, desto höhere Kühlleistungen können erzeugt werden. Somit ist die thermionische Refrigeration eine Verdampfu;igskühlung, welche auch die Möglichkeit bietet, Kühlvorrichtungen für Raumtemperatur zu konstruieren. In derartigen Kühleinrichtungen müssen die Ladungsträger nicht unbedingt ins Vakuum austreten, man kann auch ganzheitliche Festkörperanordnungen benutzen, bei denen Grenzflächen die Energiebarrieren für den Elektronenfluss bilden. Energiebarrieren von ca. 0,3 eV sind typischerweise realisierbare Werte, mit denen man eine innere thermionische Emission erzielen kann, die für ein Bauelement geeignet ist.

Die physikalischen Grundlagen der thermionischen Kühlung sowie die Beschreibung von planaren Prototypen diesbezüglicher Bauelemente sind in den folgenden Arbeiten umfassend behandelt: (i) G.D. Mahan, Mat. Res. Soc. Symp. Proc. 545, 459 (1999), (ii) Gang Chen, Mat. Res. Soc. Symp. Proc. 545, 467 (1999), (iii) A. Shakouri, Mat. Res. Soc. Symp. Proc. 545, 449 (1999), A. Shakouri, Proc. IEEE, 94, 1613-1638 (2006).

Auch hier sollen an einigen ausgewählten Beispielen im Folgenden Vor- und Nachteile der bestehenden Lösungen genannt werden.

Bekannt sind auch Arbeiten zur Realisierung von thermoelektrischen Kühlern auf Kapton-Folie, um den Einfluss des Substrates durch Verwendung schlecht wärmeleitender dünner Materialien auf die Thermoelemente möglichst gering zu halten [L.M. Goncalves, u.a., J. Micromech. Microeng. 17 (2007) S168-S173].

Nachteilig bei den Lösungen des Standes der Technik ist, dass infolge der planaren Anordnungen der thermoelektrischen Elemente der elektrische und thermische Einfluss des Substrates, auf dem die thermoelektrischen Elemente angeordnet sind, sehr groß ist. Die Wechselwirkungen mit dem Substrat, die in parasitärer Weise auf die funktionellen Parameter Einfluss nehmen, können die Effektivität der Energiewandlung beträchtlich reduzieren.

In diesem Kontext gibt es ferner Vorschläge für den Anwendungsfall makroskopischer radialer Wärmeströme, die in der Entwicklung ringförmiger thermoelektrischer Module bestehen [Gao Min u.a., Semicond. Sci. Technol. 22 (2007) 880-883]. Diese technologische Massiv-Material-Lösung lässt sich jedoch nicht in die Dünnschichttechnologie transferieren.

Weiterhin bekannt ist das Aufrollen von Festkörperschichten, wenn diese von einem Substrat abgelöst werden. Dies wurde zum Beispiel von Prinz [V. Y. Prinz, u.a, Physica E 6 (2000) 828-831] und von Schmidt [O.G. Schmidt, u.a., Nature 410 (2001) 168] beschrieben (roll-up-Technologie).

In diesen Veröffentlichungen weist die Festkörperschicht, die eine Dicke von wenigen Nanometer besitzt, einen Verspannungsgradienten in Wachstumsrichtung auf. Dies kann zum Beispiel durch ein Schichtpaar realisiert werden, in dem die beiden Schichten durch ihre chemische Zusammensetzung leicht unterschiedliche Gitterkonstanten besitzen. Zur Ausnutzung der sich ergebenden Gitterfehlanpassung, wenn man beide Schichten aufeinander abscheidet, werden die Schichten in der Reihenfolge abnehmender Gitterkonstante auf eine Opferschicht aufgebracht. Wird nun diese Opferschicht durch eine selektive Ätzlösung aufgelöst, dehnt sich die während des Schichtwachstums zusammengedrückte untere Lage aus, während sich die obere Lage, die durch die Gitterfehlanpassung gestreckt ist, zusammenzieht. Durch diese beiden Prozesse beim Ablösen vom Substrat kann es dazu kommen, dass sich das Schichtpaar aufrollt.

Dabei kann die Opferschicht auch strukturiert aufgebracht werden, so dass durch die spätere Verwendung einer selektiven Ätzlösung die Opferschicht teilweise oder komplett entfernt wird. Das Schichtenpaar wird sowohl auf die Opferschicht, als auch auf benachbarte Substratbereiche aufgebracht. Durch selektive Entfernung der Opferschicht, rollt das Schichtenpaar in diesem Bereich, während es im Bereich der direkten Haftung am Substrat nicht rollt. Nach Abschluss des Ätzvorgangs (im Falle, dass die Opferschicht vollständig entfernt ist) liegt eine Rolle vor, die in ihrer vollen Länge am Substrat haftet.

Ausgehend von diesem Ansatz sind derartige radiale elektronische Bauelemente in Dünnschichttechnologie gemäß DE 101 59 415 A1 als auch in Veröffentlichungen von Schmidt [O.G. Schmidt u.a., IEEE Journal of Selected Topics in Quantum Electronics 8, 1025 (2002) 1025-1034] und Luchnikov [V. Luchnikov, u.a., Adv. Mater. 17 (2005) 1177-1182] diskutiert. Es sind jedoch keine thermoelektrischen Funktionsmodule offenbart oder in Betracht gezogen worden.
Neben der Verwendung zweier gegeneinander verspannter Festkörperschichten, können auch Einzelschichten einen Verspannungsgradienten aufweisen. Dieser Verspannungsgradient bildet sich während des Wachstums der Schicht, durch die Fehlanpassung mit der Gitterkonstante des unterliegenden Substrats.

Nachteilig bei allen Lösungen des Standes der Technik ist, dass durch die planaren Anordnungen der thermoelektrischen Bauelemente der elektrische und thermische Einfluss des Substrates, auf dem die thermoelektrischen Bauelemente angeordnet sind, sehr groß ist. Diese parasitären Effekte nehmen zum Teil starken Einfluss auf die intrinsischen Parameter der Prozesse im Bauelement und verringern deren Effizienz.

Die Aufgabe der vorliegenden Lösung besteht in der Konzipierung eines thermoelektrischen Bauelementes, bei welchem nur sehr geringe parasitäre Effekte des Substrates auftreten und damit die Energiewandlung in effizienter Weise erfolgt. Ferner besteht die Aufgabe der vorliegenden Erfindung auch in der Angabe eines einfachen und preiswerten Verfahrens zur Herstellung des konzipierten Bauelementes.

Die Aufgabe wird durch die in den Ansprüchen angegebene Erfindung gelöst. Vorteilhafte Ausgestaltungen sind Gegenstand der Unteransprüche.

Das erfindungsgemäße thermoelektrisches Bauelement,
a) zur Ausnutzung des Peltier-Seebeck-basierten Wirkprinzips besteht aus zwei oder mehreren getrennt oder gemeinsam mittels der roll-up-Technologie aufgerollten Dünnschichten, wovon je eines aus einem p- und einem n-dotierten Halbleitermaterial besteht und diese den p- und n-leitenden thermoelektrischen Schenkel bilden, und die mäanderartig miteinander über elektrische Kontakte verbunden sind, und wobei die zwei oder mehreren aufgerollten Dünnschichten auf einem elektrisch nichtleitenden Substrat mit maximal 5 % ihrer gesamten Fläche mit den elektrischen Kontakten und dem Substrat stoffschlüssig verbunden sind, und so die zwei oder mehr Schenkel des thermoelektrischen Bauelementes bilden
   oder es besteht
b) zur Ausnutzung des thermionischen Wirkprinzipes aus einem mittels der roll-up-Technologie aufgerollten Mehrschichtaufbau aus einer Dünnschicht aus einem p-dotierten Halbleitermaterial, aus einer darauf aufgebrachten elektrisch nichtleitenden Barriereschicht, und aus einer wiederum darauf aufgebrachten Dünnschicht aus einem n-dotierten Halbleitermaterial, wobei die Abfolge der Dünnschichten mit dazwischen aufgebrachten Barriereschichten ein- oder mehrmals übereinander angeordnet und/oder in umgekehrter Reihenfolge der p- und n-dotierten Dünnschichten und dann insgesamt aufgerollt ist, und wobei die Dünnschichten jeweils elektrisch kontaktiert sind und keinerlei direkter stofflicher Kontakt zwischen ihnen vorhanden ist, und der gesamte aufgerollte Mehrschichtaufbau auf einem elektrisch nichtleitenden Substrat mit maximal 5 % seiner gesamten Fläche mit den elektrischen Kontakten und dem Substrat stoffschlüssig verbunden ist.

Vorteilhafterweise sind die mindestens zwei getrennt aufgerollten Dünnschichten zwei Thermoelemente, wobei je eines aus einem p- und einem n-dotierten Halbleitermaterial besteht, und wobei noch vorteilhafterweise eine Vielzahl von Thermoelementen vorhanden ist, die nebeneinander und/oder übereinander und die p- und n-dotierten Thermoelemente immer abwechselnd angeordnet sind und die über die elektrischen Kontakte mäanderartig miteinander verbunden sind, und wobei auch noch vorteilhafterweise die p- und n-dotierten Halbleiterschichten gemeinsam aufgerollt werden, wobei die entstehende Rolle beide thermoelektrischen Schenkel beinhaltet, wobei die p- und n-dotierten Halbleiterschichten zur Ausbildung der mäanderartigen Kontaktierung an einem Rollenende elektrisch leitend miteinander verbunden sind.

Auch vorteilhafterweise sind die aufgerollten Dünnschichten oder der aufgerollte Mehrschichtaufbau auf einem Substrat angeordnet, wobei das Substrat vorteilhafterweise aus Resten der Opferschicht, einer Barriere- oder anderen Funktionsschicht oder aus einem Si- oder GaAs-Substrat besteht.

Ebenfalls vorteilhafterweise weist das aufgerollte Dünnschichtmaterial eine Dicke von 4 nm bis 200nm und Längen von 0,5 µm bis 5 mm auf.

Weiterhin vorteilhafterweise weist der aufgerollte Mehrschichtaufbau eine Dicke von 50 nm bis 100 nm und Längen von 0.5 µm bis 5 µm auf.

Und auch vorteilhafterweise weisen die aufgerollten Dünnschichten oder der aufgerollte Mehrschichtaufbau eine vollständige Windung bis 20 Windungen auf.

Vorteilhaft ist es auch, wenn die aufgerollten Dünnschichten aus SiGe, FeSi₂, MnSi₁.₇₆, CoSb₃, PbTe, Bi₂Te₃ bestehen.

Weiterhin vorteilhaft ist es, wenn die p- und n-dotierten Schichten des Mehrschichtaufbaus aus InGaAs, AlGaAs, GaAs, Si, Ge, SiGe bestehen.

Ebenfalls vorteilhaft ist es, wenn das thermoelektrische Bauelement eine halbleitende Übergitter-Heterostruktur oder ein thermionisches Bauelement ist.

Von Vorteil ist es auch, wenn eine Vielzahl von aufgerollten Dünnschichten oder aufgerollten Mehrschichtaufbauten vorhanden sind, die nebeneinander und übereinander angeordnet sind.

Weiterhin von Vorteil ist es, wenn die aufgerollten Dünnschichten und der aufgerollte Mehrschichtaufbau weitere Funktions- und Hilfsschichten aufweisen, wobei noch vorteilhafterweise als weitere Funktions- und Hilfsschichten Isolatorschichten, Rollhilfsschichten, Abdeckschichten vorhanden sind.

Und auch von Vorteil ist es, wenn die Barriereschicht des Mehrschichtaufbaus aus AlGaAs, Oxiden oder Nitriden (Si02, SiN) besteht.

Bei dem erfindungsgemäßen Verfahren zur Herstellung eines thermoelektrischen Bauelementes werden
a) auf ein elektrisch nichtleitendes Substrat elektrische Kontakte mäanderförmig aufgebracht, nachfolgend werden eine oder mehrere elektrisch nichtleitende Opferschichten ganz oder teilweise auf das Substrat und höchstens teilweise auf die elektrischen Kontakte aufgebracht, oder eine elektrisch nichtleitende Opferschicht, die als Substrat dient, wird mit mäanderförmigen elektrischen Kontakten versehen, danach wird eine oder mehrere Schichten aus einem p-dotierten Halbleitermaterial mindestens auf Teile der elektrischen Kontakte und die Opferschicht aufgebracht, dann wird mindestens eine weitere Opferschicht aufgebracht, danach wird eine oder mehrere Schicht aus einem n-dotierten Halbleitermaterial mindestens auf Teile der elektrischen Kontakte und die Opferschicht aufgebracht, daran anschließend werden die Opferschichten teilweise oder vollständig entfernt ,
   oder es wird
b) auf ein elektrisch nichtleitendes Substrat mit elektrischen Kontakten eine elektrisch nichtleitende Opferschicht aufgebracht, oder eine elektrisch nichtleitende Opferschicht, die als Substrat dient, wird mit elektrischen Kontakten versehen, darauf wird eine Schicht aus einem p-dotierten Halbleitermaterial nachfolgend eine elektrisch nichtleitende Barriereschicht und darauf eine Schicht aus einem n-dotierte Halbleitermaterial aufgebracht, wobei die Aufbringung der Halbleitermaterialschichten derart erfolgt, dass keinerlei direkter stofflicher Kontakt zwischen diesen Schichten oberhalb und unterhalb der Barriereschicht realisiert wird, dann die Opferschicht teilweise oder ganz entfernt wird,
c) und wobei die Aufbringung der Schichten für a) und b) aus dem p- oder n-dotierten Halbleitermaterial und der Barriereschichten derart erfolgt, dass in den Schichten aus dem p- oder n-dotierten Halbleitermaterial und der Barriereschichten ein Spannungsgradient vorliegt, der nach der Entfernung der Opferschicht(en) zum Aufrollen der Schicht aus einem p- und/oder n-dotierten Halbleitermaterial und der Barriereschichten führt,
d) und wobei das Aufrollen nach a) und b) so durchgeführt wird, dass die Dünnschichten nach a) und der Mehrschichtaufbau nach b) nach dem Aufrollen jeweils mit maximal 5 % ihrer gesamten Fläche mit den elektrischen Kontakten und dem Substrat stoffschlüssig verbunden sind,
e) und wobei die Anordnung der aufgerollten Schichten nach a) und b) aus einem p- oder n-dotierten Halbleitermaterial auch in umgekehrter Reihenfolge realisierbar ist und/oder neben- oder übereinander realisiert wird, oder beim Mehrschichtaufbau die unter b) genannte Schichtabfolge ein- oder mehrmals übereinander realisiert wird,

Vorteilhafterweise werden als Opferschicht elektrisch nichtleitende, organische Opferschichtmaterialien eingesetzt.

Ebenfalls vorteilhafterweise wird auf die elektrischen Kontakte und die Opferschicht(en) eine Rollhilfsschicht und darauf dann mindestens teilweise die Schicht aus einem p- oder n-dotierten Halbleitermaterial aufgebracht, wobei noch vorteilhafterweise als Rollhilfsschicht eine Schicht aus Al₂O₃, SiO₂ oder Si₃N₄ aufgebracht wird.

Weiterhin vorteilhafterweise wird das Entfernen der Opferschicht durch Ätzen mit Säuren oder Laugen oder durch Lösen mit Wasser oder Lösungsmitteln durchgeführt.

Und auch vorteilhafterweise werden nach dem Aufbringen der Opferschicht oder Opferschichten diese strukturiert, wobei die Strukturierung vorteilhafterweise mittels lithografischer Verfahren realisiert wird.

Vorteilhaft ist es auch, wenn die Schichten aufgebracht werden, wobei während des Aufbringens der Schicht aus einem p- oder n-dotierten Halbleitermaterial innerhalb der Schicht ein Verspannungsgradient durch Gitterfehlanpassung ausgebildet wird.

Ebenfalls vorteilhaft ist es, wenn auf das Substrat eine Opferschicht teilweise aufgebracht und nachfolgend mindestens eine Schicht aus einem p-dotierten Halbleitermaterial, darüber eine Schicht aus Isolatormaterial und darüber eine Schicht aus einem n-dotierten Halbleitermaterial aufgebracht wird, wobei die gegensätzlich dotierten Halbleiterschichten entlang einer Kante durch die Schicht aus einem Isolatormaterial hindurch elektrisch miteinander verbunden werden, wobei noch vorteilhafterweise die elektrischen Kontaktierung der beiden gegensätzlich dotierten Halbleiterschichten entlang der Kante erfolgt, die genau jener Kante gegenüber liegt, entlang der beide Halbleiterschichten bereits elektrisch miteinander verbunden sind.

Und auch vorteilhaft ist es, wenn ein Substrat eingesetzt wird, welches aus einem elektrisch nichtleitenden Material besteht, oder aus Resten der Opferschichten, oder aus Barriere- oder anderen Funktionsschichten besteht.

Von Vorteil ist es auch, wenn auf alle aufgebrachten Schichten eine Schicht aus einem Isolatormaterial komplett überdeckend aufgebracht wird, so dass während des Aufrollprozesses durch Auflösen der Opferschicht keine zusätzliche elektrische Kontaktierung entsteht.

Und ebenfalls vorteilhaft ist es, wenn eine oder mehrere Schichten aus einem p-dotierten Halbleitermaterial mindestens auf Teile der elektrischen Kontakte und auf eine Opferschicht aufgebracht werden, dann mindestens eine elektrisch nichtleitende Barriereschicht aufgebracht wird, danach eine oder mehrere Schichten aus einem n-dotierten Halbleitermaterial mindestens auf Teile der elektrischen Kontakte und die Barriereschicht aufgebracht werden, und daran anschließend die p- und n-dotierten Halbleiterschichten an dem den Kontakten gegenüberliegenden Rollenende elektrisch miteinander verbunden werden, und dann die Opferschicht vollständig entfernt wird.

Mit der erfindungsgemäßen Lösung liegen thermoelektrische Bauelemente vor, mit welchen eine elektrische Leistung oder eine thermische Kühlleistung erzeugt werden kann. Das erfindungsgemäße thermoelektrische Bauelement kann also als Thermogenerator oder als Kühler fungieren. Aufgrund der erfindungsgemäßen räumlichen Gestaltung der einzelnen Thermoelemente in aufgerollter Form kommt es zu der funktionellen Besonderheit, dass die den Ladungsträgerstrom führenden aufgerollten Thermoelemente gleichzeitig als Wärmestromführung genutzt werden können. Damit wird gemäß der erfindungsgemäßen Lösung eines thermischen Energiekonverters die aus den bekannten Lösungen von planaren Anordnungen der Thermoelemente bekannte Trennung zwischen elektrischer Funktionalität und thermischen Management aufgehoben und erstmals ein thermoelektrisches Bauelement angegeben, dessen Konstruktion den Energiewandlungsprozess einschließlich des erforderlichen thermischen Handlings in optimaler Weise intrinsisch miteinander verbindet.

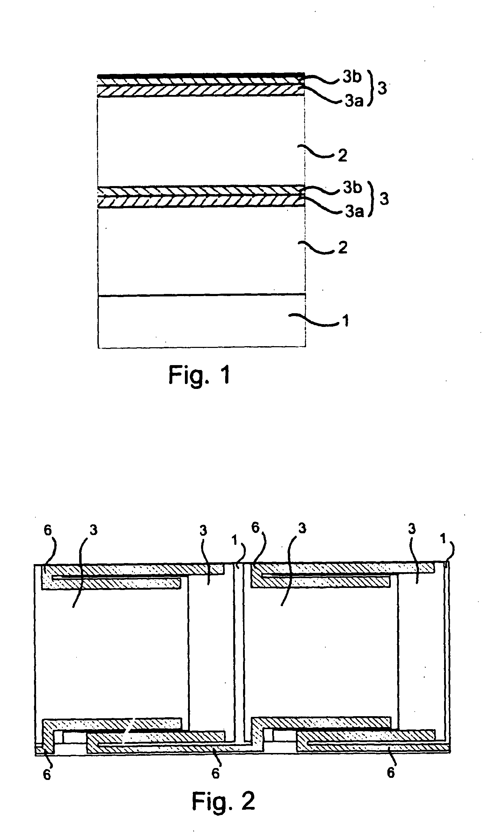

Bezüglich der räumlichen Orientierung von Wärmestrom und Temperaturgradient ist festzustellen, dass der Temperaturgradient bevorzugt entlang der Zylinderachse der aufgerollten Schichten ausgenutzt oder erzeugt wird. Diese Geometrie ermöglicht es, die erfindungsgemäße Anordnung für die Kühlung von "hot spots" zu verwenden. In diesem Falle sind die zwei oder mehr aufgerollten Dünnschichten mäanderartig über elektrische Kontakte verbunden. Für die vorliegende Erfindung soll unter einer mäanderartigen Kontaktierung der Dünnschichten beispielsweise im Falle von je einer aufgerollten p- und n-dotierten Dünnschicht verstanden werden, dass der elektrische Kontakt von der Stromquelle zu dem einen Rollenende der p-dotierten aufgerollten Dünnschicht geführt ist, vom anderen Rollenende der p-dotierten aufgerollten Dünnschicht dann zum am nächsten liegenden Rollenende der n-dotierten aufgerollten Dünnschicht und vom anderen Rollenende der n-dotierten Dünnschicht zur Stromquelle zurück. In diesem Falle (siehe auch Fig. 2) verläuft der Temperaturgradient axial (achsig) entlang der aufgerollten Dünnschichten von dem direkt verbundenen Rollenenden der p- und n-dotierten aufgerollten Dünnschichten zu den Rollenenden, die mit der Stromquelle verbunden sind.

Mit der erfindungsgemäßen Lösung liegt weiterhin ein thermionisch arbeitendes Bauelement vor, in dem ein radialer Temperaturgradient in einem aufgerollten Mehrschichtaufbau erzeugt wird. Aufgrund der erfindungsgemäßen räumlichen Gestaltung des zylindrischen Bauelementes in aufgerollter Form kommt es zu der funktionellen Besonderheit, dass die den Ladungsträgerstrom führenden aufgerollten Bauelemente gleichzeitig als Wärmestromführung ausgenutzt werden.

Je nach Polarität der an die inneren und äußeren Elektroden angelegten Anregungsspannung kann der entstehende Temperaturgradient entweder nach außen oder nach innen gerichtet sein, d.h. die kalte Elektrode kann sowohl innen als auch außen liegen. Wird diese Anordnung in einem strömenden Medium betrieben, so kann die an den Elektroden generierte Temperatur an dieses übertragen werden und so an einem anderen Ort transferiert werden, um z.B. als Kälteleistung angewandt zu werden. Daraus ergibt sich die Möglichkeit einen räumlich senkrecht zum Temperaturgradienten stehenden Wärmestrom zu generieren, d.h. parallel zur Zylinderachse der aufgerollten Schichten.

Mit der erfindungsgemäßen Lösung werden die elektrischen und vor allem aber die thermischen Substratverluste (parasitärer Einfluss des Substrates) nahezu gegen Null geführt, da der stoffschlüssige Kontaktbereich mit den elektrischen Kontakten auf dem Substrat maximal 5 % der gesamten aufgerollten Fläche einer Schicht aus einem p- und/oder n-dotierten Halbleitermaterial beträgt.
Dabei ist im Rahmen der vorliegenden Erfindung unter der stoffschlüssigen Verbindung zu verstehen, dass maximal 5 % der gesamten aufgerollten Fläche der Dünnschichten mit den elektrischen Kontakten und auch mit dem Substrat stoffschlüssig verbunden sind. Das Substrat ist im Rahmen der vorliegenden Erfindung immer elektrisch nicht leitend und kann beispielsweise aus Resten der Opferschicht, einer Barriere- oder anderen Funktionsschicht oder allgemein aus einem Substrat bestehen.

Vorteile der erfindungsgemäßen Lösung liegen
- in ihrer Skalierbarkeit in den Abmessungen von mm-Bereich über den µm-Bereich bis in den nm-Bereich,
- in ihrer Integrierbarkeit in bekannte Si-Technologie-basierte Elektronik und Hybrid-Elektronik,
- in ihrer Ausnutzung einer breiten Materialauswahl an n- und p-dotierten Halbleitermaterialien,
- in ihrer Anwendung insbesondere bei der Kühlung von dynamischen "hot spots", da die Kühlleistung unmittelbar vor Ort bereitgestellt werden kann, und
- in ihrer strukturellen Modifizierbarkeit.

Die strukturelle Modifizierbarkeit der erfindungsgemäßen Lösung besteht darin, dass diese sich sowohl als Mehrschichtaufbau aus einem p- oder n-dotierten Halbleitermaterial realisieren lässt, als auch auf Basis thermoelektrischer Schichten von morphologisch unterschiedlichem Zustand, wie z.B. von amorphen, polykristallinen, texturierten oder epitaktischen Schichten. Dabei kann es im Einzelfall erforderlich sein, Rollhilfsschichten auf Basis verspannter Festkörperschichten zu verwenden.

Weitere Vorteile der erfindungsgemäßen Lösung ergeben sich aus der Aufroll-Technologie, vor allem aus ihrem "selbstorganisierten" Herstellungsprozess. Die Spannungszustände in den aufgerollten Dünnschichten können gegenüber vergleichbaren Bauelementen, die nach der Planartechnologie hergestellt worden sind, deutlich minimiert werden, was ebenfalls positiven Einfluss auf die thermoelektrische Effizienz ausübt.

Durch die elektrische und thermische Separierung der thermoelektrischen Bauelemente vom Substrat während des Herstellungsprozesses kann ein positiver Einfluss auf die Gesamteffizienz Z*T der einzelnen Thermoelemente und damit des Gesamtsystems erreicht werden. Weiterhin kann mit Hilfe der erfindungsgemäßen Lösung dank der aufgerollten Dünnschichten im Falle des Einsatzes in gasförmigen und flüssigen Medien eine intrinsische Wärmestromführung realisiert werden.

Schließlich ist die vorgeschlagene Anordnung wegen des skalierbaren Längen-Durchmesser-Verhältnisses der aufgerollten Dünnschichten mit großen Temperaturgradienten belastbar, was für einen hohen Wirkungsgrad dienlich ist. Zur Erhöhung der Dichte thermoelektrischer Funktionselemente auf dem Substrat kann das von Deneke [C. Deneke und O.G. Schmidt, Physica E 23 (2004) 269-273] vorgeschlagene Unterätzen zweier Verspannungsträger genutzt werden. Dabei liegen zwei Stapel, die aus je einer Opferschicht und einer verspannungstragenden Doppelschicht bestehen, übereinander. Die identische Zusammensetzung der Opferschichten ermöglicht deren paralleles selektives Ätzen und die Ausbildung zweier Rollen auf dem Substrat. Es werden jedoch keinerlei elektronische oder thermoelektrische Bauelemente auf Basis dieser verdoppelten Strukturen in Betracht gezogen.

Erfindungsgemäß kann das thermionisch arbeitende Bauelement im Falle des Einzelbarrierenmodells nur aus einer Windung des aufgerollten Mehrschichtaufbaus bestehen. Dazu müssen dann Windungsanfang und -ende des Mehrschichtaufbaus kontaktfrei voneinander fixiert werden. Dazu kann vorteilhafterweise das freie Windungsende mit einer Beschichtung aus einem elektrisch isolierenden Material versehen sein, oder im möglichen Kontaktbereich des Windungsendes mit dem Mehrschichtaufbau eine elektrisch isolierende Schicht aufgebracht sein.
In Übergitterstrukturen nach dem Multibarrierenmodell bestehen diese Anforderungen nicht. Hier müssen Layoutvarianten zum Einsatz kommen, um einen inneren und einen äußeren Kontakt an den "roll-up" Strukturen unmittelbar während der Rollenbildung zu erhalten.

Bezüglich des räumlichen Aufbaus des erfindungsgemäßen thermionisch arbeitenden Bauelementes ist zu sagen, dass als erste Funktionsschicht auf den ersten elektrischen Kontakt entweder eine Schicht aus einem p-dotierten oder n-dotierten Halbleitermaterial aufgebracht werden kann. Nachfolgend muss eine Barriereschicht aus einem elektrisch isolierenden Material und/oder eine komplementäre Halbleiterschicht aufgebracht werden in Abhängigkeit davon ob es sich um eine Einzel- oder Vielfachbarrieren-Anordnung handelt. Vervollständigt wird der Schichtaufbau schließlich mit dem jeweils noch fehlenden p-dotierten oder n-dotierten Halbleitermaterial, sowie dem Kontaktmaterial für den zweiten Kontakt.

Weitere Vorteile der erfindungsgemäßen Lösung bestehen darin, dass:
- sich thermionisch arbeitende Strukturen sowohl als Einzelbarrierenelemente als auch als periodische Übergitterstrukturen realisieren lassen,
- die zylindrischen Strukturen der thermionisch arbeitenden Bauelemente eine höhere Effizienz bieten, da sich ihre Schwellwertspannung gegenüber planaren Anordnungen absenken lässt,
- durch das erfindungsgemäße Verfahren radiale Übergitterstrukturen herstellbar sind,
- das erfindungsgemäße Verfahren mit der sogenannten Complementary-Metal-Oxide-Semiconductor (CMOS)-Technologie integrieren lässt und "on-a-chip"-Elemente herstellbar sind,
- mit den erfindungsgemäßen Bauelementen die Kühlung von dynamischen "hot spots" erreicht werden kann, da die Kühlleistung unmittelbar vor Ort bereitgestellt wird.

Zur Verbesserung der thermischen Effizienz, im Besonderen bei der Nutzung von Siliziumsubstraten, kann auf der Substratrückseite ein Abdünnungsbereich eingebracht werden, welcher parasitäre Wärmeströme über das Substrat minimiert.

Die Einkopplung der Wärme kann in der vorgeschlagenen Anordnung direkt über den Kontakt zum Substrat erfolgen, oder über Wärmeleiter an die heiße Seite der Thermoelementkaskade herangeführt werden.

Auf die aufzurollenden Schichten, die gleichzeitig die Träger der thermoelektrischen Funktion sein können, können weitere Lagen thermoelektrisch relevanter Materialien (FeSi₂, MnSi₁.₇₆, CoSb₃, PbTe, Bi₂Te₃) flächig aufgebracht werden. Die Aufbringung kann dabei über die thermische Verdampfung, Molekularstrahlepitaxie oder Sputtern erfolgen. In diesem Falle würden die aufzurollenden Schichten, die als Verspannungsträger dienen, keine Funktionsträger sein und lediglich als Rollhilfsschichten dienen. Als Verspannungsträger dient diejenige Schicht oder Schichten im Schichtverbund, welches eine Verspannung in sich trägt und das Aufrollen des Schichtverbundes initiiert. Dies kann beispielsweise eine Rollhilfsschicht sein.

Als Materialien für die aufzurollenden Schichten können zum Beispiel kristalline Halbleitermaterialien, wie SiGe oder GaAs mit den Opferschichten aus SiO2 beziehungsweise AlAs präpariert werden (Ätztechnologie). Für polykristalline und amorphe Thermoelektrika, die sich bei niedrigen Temperaturen abscheiden lassen, können auch organische Photolacke oder Hydrogele als Opferschicht verwendet werden (Resisttechnologie). Die Abscheidung der aufzurollenden Schichten und gegebenenfalls weiterer Komponenten kann durch Aufdampfen oder Sputtern auf die Photolack-Opferschicht erfolgen. Zur Strukturierung können Schattenmasken zum Einsatz kommen. Die Photolack-Opferschicht kann beispielsweise durch ein organisches Lösungsmittel selektive gelöst werden. Die freiwerdende Verspannung in den aufzurollenden Schichten führt zu deren Wölbung und der Aufrollvorgang setzt ein.

Nachfolgend wird die Erfindung an mehreren Beispielen näher erläutert.

Die Kurzbeschreibungen der zugehörigen Abbildungen sind hier zusammengefasst.
- Fig. 1: Querschnittsansicht der Stapelung zweier Kombinationen aus Opferschicht und verspannten Doppelschichten;
- Fig. 2: Verspannte Doppelschichten nach Strukturierung mit aufgebrachten metallischen Leitbahnen;
- Fig. 3: Draufsicht der Struktur nach Fig. 4;
- Fig. 4: Ansicht der fertigen Struktur aus n- und p-leitenden Rollen;
- Fig. 5: Draufsicht auf mäanderartige elektrische Verschaltung von Paaren aus n- und p-leitenden Rollen;
- Fig. 6: Ansicht vollständig prozessierten Struktur, wobei die thermoelektrischen Schenkel aus Paaren von n- und p-leitenden Rollen gebildet werden;
- Fig. 7: Schichtaufbau zur Erzeugung einer gerollten Struktur;
- Fig. 8: Draufsicht auf Schichtaufbau mit Kontaktierung zur Erstellung einer Rolle, die n- und p-leitenden thermoelektrischen Schenkel in sich vereint;
- Fig. 9: Schichtaufbau zur Erzeugung einer gerollten Struktur;
- Fig. 10: Ansicht des gefertigten thermoelektrischen Bauelements, das n- und p-leitenden thermoelektrischen Schenkel in einer Rolle vereint;
- Fig. 11: Querschnittsansicht einer Stapelung zur Ausnutzung thermionischer Effekte;
- Fig. 12: Draufsicht auf Struktur nach Fig. 11;
- Fig. 13: vollständig prozessierte Struktur;
- Fig. 14: gerollte Übergitterstruktur bereits vollständig prozessiert;

### Beispiel 1

Auf ein GaAs-Substrat (1) wird zunächst eine Opferschicht (2) aus AlAs mittels Aufdampfen aufgebracht (Fig.1). Anschließend erfolgt die Abscheidung der ersten Doppelschicht (3) die als erster Verspannungsträger dient. Diese Doppelschicht (3) besteht aus einer unteren Lage (3a) und einer oberen Lage (3b), wobei die untere Lage eine größere Gitterkonstante als die obere Lage aufweist. Die untere Lage ist eine 20 nm dicke Schicht aus InGaAs, während die obere Lage aus 30 nm reinem GaAs besteht. Dazu werden die Doppelschichten während der Abscheidung zur Bereitstellung einer n-Dotierung mit Silizium dotiert. Anschließend erfolgt die Abscheidung einer weiteren Opferschicht (2) und der zweiten Doppelschicht (3), die als zweiter Verspannungsträger dient, jeweils aus den gleichen Materialien und Abmessungen. Die beiden Opferschichten (2) sind elektrisch isolierend. Die zweite Doppelschicht (3) erhält eine p-Dotierung mit Zink.

Um die erste und zweite Doppelschicht (3) getrennt voneinander aufrollen zu können, ist eine Strukturierung des Gesamtsystems aus Opferschichten (2) und Doppelschichten (3) notwendig. Dieser Prozess erfolgt durch Aufbringen einer Fotomaske und einen anschließenden Ätzprozess ("shallow etch"). Dabei werden Randbereiche der zweiten Doppelschicht (3) und der zweiten Opferschicht (2) soweit entfernt, dass eine Kontaktierung der ersten Doppelschicht (3) entlang der Rollrichtung realisiert werden kann. Damit entstehen auch Startkanten, an denen der Aufrollvorgang der zweiten Doppelschicht (3) in Gang gesetzt werden kann. Danach werden in einem weiteren Lithografie- und Ätzschritt ("deep etch") die Startkanten für den Aufrollvorgang der ersten Doppelschicht (3) erzeugt.

Auf die teilweise freigelegten Bereiche der ersten Doppelschicht (3) und die Randbereiche der zweiten Doppelschicht (3) werden metallische Leiterbahnen (6) aus Aluminium aufgebracht. Nach Fig. 2 verlaufen die Leiterbahnen (6) dabei parallel zur Rollrichtung möglichst nah an den Seitenkanten der Doppelschichten (3). Die Verbindungen zwischen diesen Leiterbahnen (6) sind so gewählt, dass sich zusammen mit den entstehenden Rollen eine elektrische Reihenschaltung aller Elemente ergibt. Im nächsten Schritt werden die beiden Doppelschichten (3) aufgerollt.

Das selektive Ätzen der AlAs-Opferschichten (2) in Flusssäure (HF) als Ätzmittel führt dazu, dass sich die zwei Doppelschichten (3) voneinander und vom Substrat (1) lösen und, der eingebauten Gitterfehlanpassung folgend, ein Aufrollen einsetzt. Dabei werden alle Schichten mitgenommen. Durch den Ablösevorgang kann die Gitterfehlanpassung in den verspannten Doppelschichten relaxieren, so dass sich die leicht gepresste Struktur der unteren Lage (3a) ausdehnt, während sich die leicht gestreckte Struktur der oberen Lage (3b) zusammenzieht. Dies führt dazu, dass sich das gesamte Schichtsystem vom Substrat weg wölbt und ein Rollvorgang in Gang gesetzt wird. Bei diesem Rollprozess werden die auf den Doppelschichten (3) befindlichen Leiterbahnen eingerollt. Das Aufrollen aller Doppelschichten erfolgt in die gleiche Richtung. Das Aufrollen stoppt, wenn der Bereich der Verbindung zwischen den Leiterbahnen (6) erreicht ist.

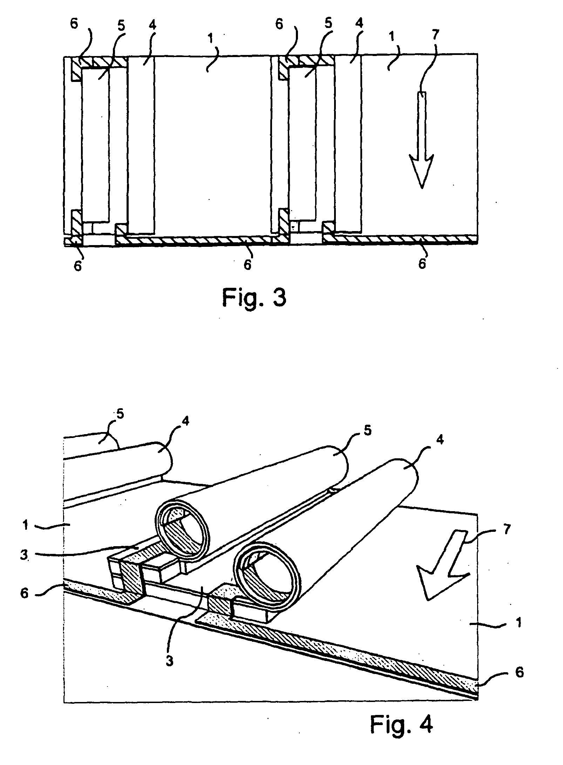

Fig. 4 zeigt das Ergebnis des Aufrollvorgangs mit der kompletten Struktur, in der auch die elektrische Reihenschaltung der abwechselnd n- (4) und p-leitenden (5) Rollen (thermoelektrische Funktionselemente = n- und p-leitender Schenkel des thermoelektrischen Bauelements) zu erkennen sind. Nach Fig. 3 sind auch die mäanderartig angeordneten Kontakte (6) zu sehen. Der Temperaturgradient (7) verläuft entlang der thermoelektrischen Funktionselemente.

### Beispiel 2

Auf einem Si-Substrat wird zunächst eine Opferschicht (2) aus Ge mittels Sputtern aufgebracht (siehe Fig. 1). Anschließend erfolgt die Abscheidung der ersten Doppelschicht (3) die als erster Verspannungsträger dient. Diese Doppelschicht (3) besteht aus einer unteren Lage (3a) und einer oberen Lage (3b), wobei die untere Lage eine größere Gitterkonstante als die obere Lage aufweist. Die untere Lage ist eine 10 nm dicke Schicht aus GeSi mit einem Überschuss an Ge, während die obere Lage ebenfalls aus 10 nm GeSi mit einem Überschuss an Si besteht. Dazu werden die Doppelschichten (3) während der Abscheidung zur Bereitstellung einer n-Dotierung mit Phosphor dotiert. Anschließend erfolgt die Abscheidung einer weiteren Opferschicht (2) und der zweiten Doppelschicht (3) jeweils aus den gleichen Materialien und Abmessungen, wobei die zweite Doppelschicht eine p-Dotierung mittels Aluminium erhält.

Diese Schichtfolge wird nun mittels fotolithografischer Masken und anschließender Ätzprozesse strukturiert. Dabei werden sowohl Startkanten für den späteren Aufrollprozess erzeugt, als auch der zweite Verspannungsträger (3) strukturiert. Durch den letztgenannten Vorgang, wird der erste Verspannungsträger (3) in soweit freigelegt, dass eine elektrische Kontaktierung in Form von Leiterbahnen entlang der Seitenkanten aufgebracht werden kann. Auf beide Verspannungsträger werden elektrische Kontakte (6) aus Gold entlang der Seitenkanten und damit parallel zur späteren Rollrichtung aufgebracht.

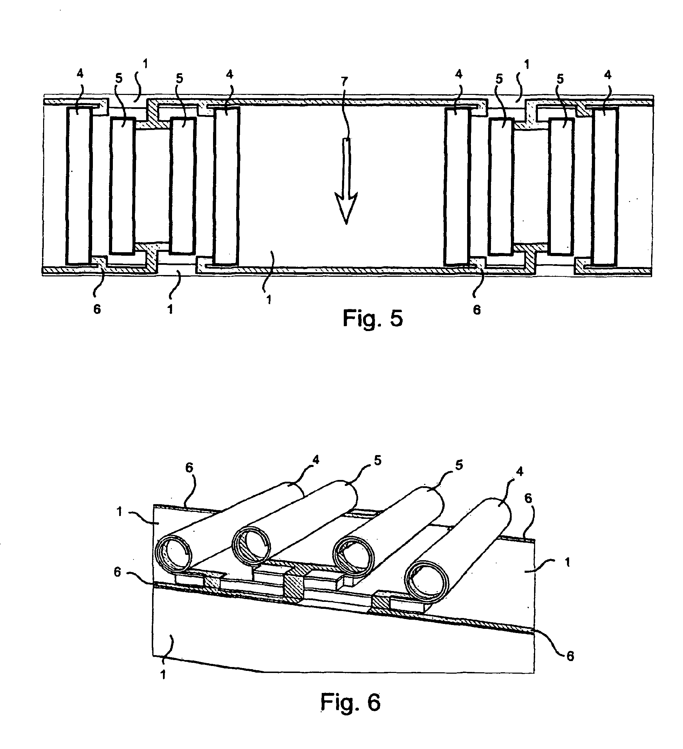

Durch selektives Ätzen der Ge-Opferschichten (2) mit H2O2 werden beide verspannten Doppelschichten (3) aufgerollt. Die Kontaktierung der Rollen, die thermoelektrische Funktionselemente sind und die Schenkel des thermoelektrischen Bauelements bilden, wird so vorgenommen, dass eine elektrische Reihenschaltung mit einander abwechselnden Paaren aus n- und p-leitenden Rollen entsteht (Fig. 5). Jeweils zwei Elemente (Rollen) der gleichen Ladungsträgerart sind somit elektrisch als auch thermisch parallel geschaltet und bilden jeweils einen thermoelektrischen Schenkel (Fig. 6). Alle Rollen sind thermisch parallel geschaltet. Der Temperaturgradient (7) verläuft entlang der thermoelektrischen Funktionselemente.

### Beispiel 3 :

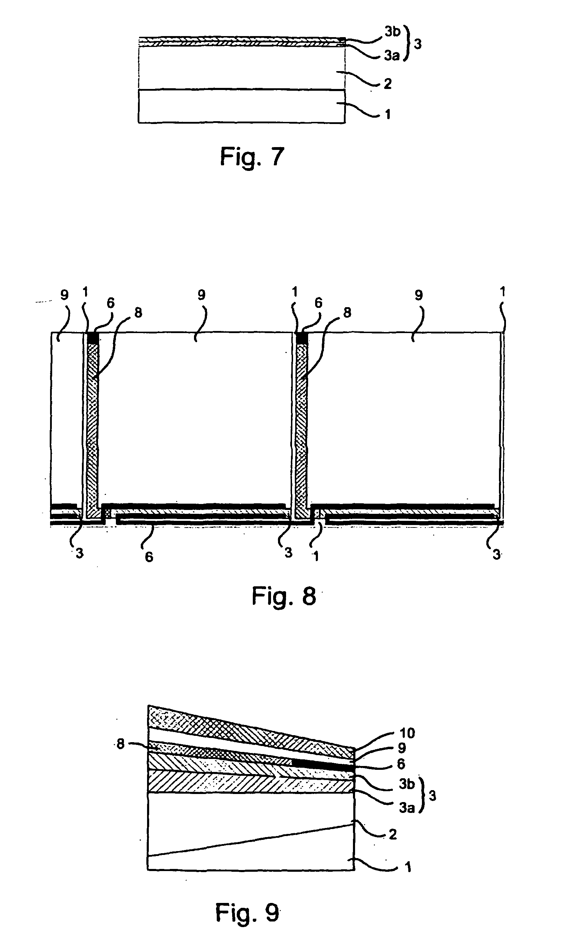

Gemäß Fig. 7 wird auf ein GaAs-Substrat (1) eine AlAs-Opferschicht (2) mittels Aufdampfen strukturiert abgeschieden, so dass Bereiche das Substrats nicht von der Opferschicht bedeckt werden, da sie später als Träger der elektrischen Kontaktierung zwischen den thermoelektrischen Funktionselementen dienen sollen. Auf diese AlAs-Opferschicht (2) wird anschließend eine Doppelschicht (3), die als Verspannungsträger dient, mittels Sputtern abgeschieden. Die Doppelschicht (3) besteht aus zwei Lagen mit zueinander leicht unterschiedlichen Gitterkonstanten. Die Reihenfolge der beiden Lagen wird dabei so gewählt, dass direkt auf der AlAs-Opferschicht (2) die Lage aus lnGaAs mit einem relativen Überschuss an InAs mit der größeren Gitterkonstante (3a), und anschließend die Lage aus GaAs mit der kleineren Gitterkonstante (3b) abgeschieden wird. Beide Lagen der Doppelschicht (3) sind mit einer n-Dotierung (Si) versehen.

Auf diese in sich verspannten Doppelschichten (3) wird nun eine Schicht aus Al_{0,33}Ga_{0,67}AS zur Zwischenisolation eine Barriereschicht (8) mittels Aufdampfen aufgebracht. Diese wird nicht durch den späteren Ätzprozess der Opferschicht (2) angegriffen. Die Zwischenisolation (8) ist dabei so zu strukturieren, dass parallel zur späteren Rollrichtung metallische Kontaktstreifen aus Aluminium (6) auf den Verspannungsträger (3) aufgebracht werden können.

Die metallischen Kontaktstreifen dienen sowohl zur Kontaktierung benachbarter Rollen untereinander (immer am vorderen Ende der Rollen), als auch zur Kontaktierung der des n-leitenden Verspannungsträgers (3) mit einer im weiteren aufzubringenden zweiten thermoelektrischen Funktionsschicht (9). Diese GaAs-Schicht wird dabei so abgeschieden, dass der hintere Kontaktstreifen überdeckt wird, während der vordere Kontaktstreifen nicht bedeckt wird. Durch Dotierung mit Zink ist die obere thermoelektrische Funktionsschicht (9) p-leitend.

Auf die p-leitende GaAs-Schicht (9) wird nun mittels fotolithografischer Masken ein Kontaktstreifen (6) strukturiert so aufgebracht, dass er mit dem Kontaktstreifen (6) auf dem n-leitenden Verspannungsträger (3) verbunden ist. Dazu ist es notwendig, den Kontaktstreifen über den Zwischenisolator (8) verläuft (Fig. 8).

Abschließend wird eine weitere Isolationsschicht (10) aufgebracht, die sich über die gesamte Fläche des sich auf der Doppelschicht (3) befindlichen Schichtsystems erstreckt. Die obere Isolationsschicht (10) liegt nach dem Aufrollvorgang zwischen p- und n-leitender Schicht der Windungsaußenseite jeder Windung der Rollen. In Fig. 9 wird ein Schnittbild durch die komplette Schichtstruktur im Bereich der direkten Kontaktierung zwischen p- und n-leitender Schicht gezeigt.

Durch selektives Ätzen der AlAs-Opferschicht (2) mit HF als selektivem Ätzmittel wird der verspannte Schichtaufbau entlang seiner Startkante vom Substrat (1) gelöst und bewegt sich von diesem weg. Bei diesem Aufrollen werden sowohl die n-leitende Lage der Doppelschicht (3), als auch die darauf aufgebrachte Schichtfolge aus Zwischenisolation (8) mit elektrischer Zwischenkontaktierung (6), p-leitender Schicht (9) und der zweiten Isolationsschicht (10) und die bereits eingebrachten elektrischen Leitbahnen (6) zur Kontaktierung der einzelnen Bestandteile erfasst.

Mit der Dauer des Ätzprozesses kann die Anzahl der entstehenden Windungen beziehungsweise der zurückgelegte Rollstrecke festgelegt und gesteuert werden.

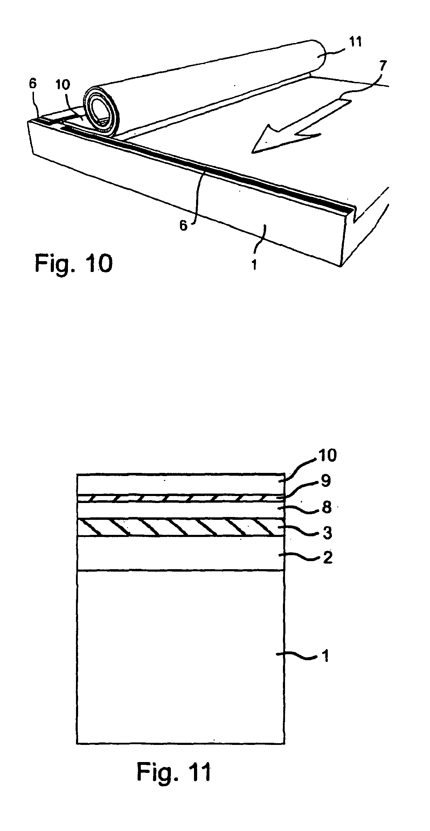

Das Ergebnis des Aufrollens ist eine vollständige thermoelektrische Funktionseinheit (11) gemäß Fig. 10 Innerhalb einer Rolle sind beide thermoelektrischen Schenkel enthalten. Durch die Wahl der Kontaktierung sind die beiden Schenkel elektrisch in Reihe geschaltet. Die beiden Reservoirs (Wärmequelle und -senke) sollen sich dabei an der Vorder- beziehungsweise an der Rückseite der Rolle befinden. Damit sind beide Schenkel thermisch parallel geschaltet, die Richtung des Wärmegefälles (7) verläuft also axial entlang des Funktionsträgers.

### Beispiel 4:

Entsprechend Fig. 11 wird auf ein GaAs-Substrat (1) eine AlAs-Opferschicht (2) der Dicke 40 nm aufgebracht, die wiederum eine Lage aus InGaAs (3) der Dicke 30 nm trägt. Diese Lage InGaAs weist einen Verspannungsgradienten in Wachstumsrichtung auf, der sich während des Wachstums der Schicht ausbildet. In ausgewählten Bereichen werden darauf 50 nm AlGaAs (8) als Barriereschicht und auf dieser 20 nm GaAs (9) als zweite elektrisch leitende Schicht aufgebracht.
Zur Initialisierung des späteren Aufrollprozesses wird mittels fotolithografischer Strukturierung und anschließendem reaktivem lonenstrahlätzen eine Startkante erzeugt, die sich durch alle aufgebrachten Schichten bis an das Substratmaterial fortsetzt.

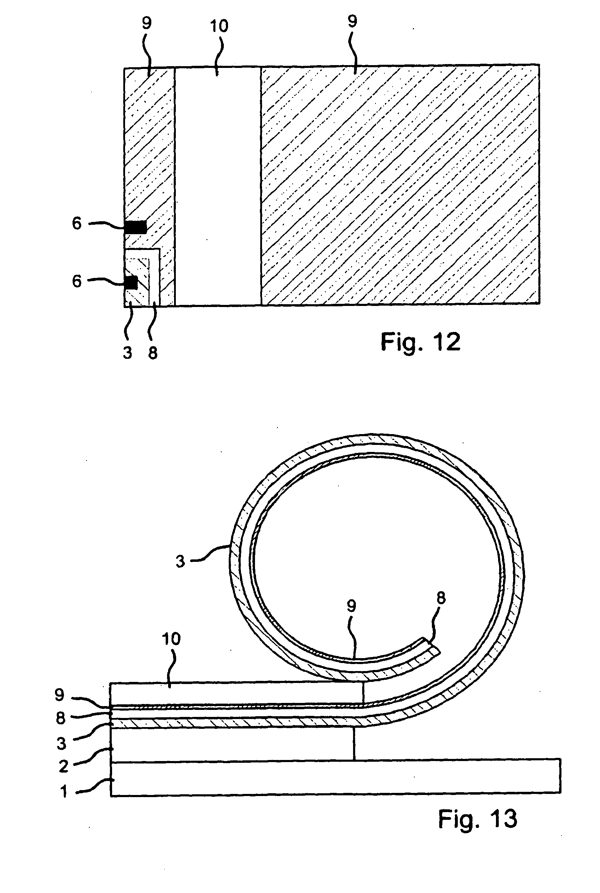

Zur Vermeidung eines direkten elektrischen Kontakts zwischen oberer und unterer Halbleiterschicht wird, wie in Fig. 12 gezeigt eine Isolierschicht (10) aus Si3N4 so parallel zur Startkante aufgebracht, das sich während des Aufrollprozesses genau eine Windung ausbilden kann und der Windungsanfang auf dieser Isolierschicht zu liegen kommt. Durch die Isolierschicht wird auch der Aufrollvorgang beendet, da diese Schicht einen Verspannungsgradienten in zum Substrat gewandter Richtung besitzt. Die Strukturierung erfolgt während des Aufdampfens durch Schattenmasken.

Im nicht zu rollenden Bereich werden metallische Zuleitungen (6) aus Gold auf die beiden leitenden Schichten mittels Sputtern abgeschieden. Die Strukturierung erfolgt durch vorher aufgebracht Photomasken.

In einem selektiven Ätzprozess mittels HF, der die AlAs-Opferschicht selektiv entfernt, wird nun der Aufrollvorgang entlang der Startkante gestartet. Durch den Verspannungsgradienten im System der drei Schichten InGaAs/A1GaAs/GaAs wölben diese sich vom Substrat weg und rollen in Richtung der Isolierschicht (10) aus Si3N4. Der Aufrollvorgang stoppt durch den entgegengesetzten Verspannungsgradienten dieser Isolierschicht. Die vollständig prozessierte Struktur ist in Fig. 13 gezeigt.

### Beispiel 5:

Auf ein Siliziumsubstrat (1) wird eine SiO₂-Opferschicht (2) der Dicke 30 nm aufgebracht. Darauf folgt die Abscheidung einer Doppelschicht (3) aus Silizium und Germanium. Diese beiden Lagen zeigen durch ihre Gitterkonstanten eine Gitterfehlanpassung, die sich in einem Verspannungsgradienten in Wachstumsrichtung äußert.

Mittels reaktivem lonenätzens wird eine Startkante erzeugt, entlang der später der selektive Ätzprozess einsetzt. Die Strukturierung erfolgt mit optischer Lithografie. Ebenso mit optischer Lithografie wird die Struktur zweier metallischer Kontaktstreifen vorgegeben. Beide Kontaktstriefen verlaufen parallel der Startkante, wobei der Erste mit einer Breite von 5µm direkt an der Startkante liegt und mit einer Zuleitung entlang einer Seitenkante (parallel zur späteren Rollrichtung) verbunden wird. Der zweite Kontaktstriefen, der den späteren äußeren Kontakt bildet, wird so vorgesehen, dass er von der letzten Windung erfasst wird und der Aufrollvorgang damit gleichzeitig zum Erliegen kommt. Je nach beabsichtigter Anzahl von Rotationen ist der Abstand des zweiten Kontaktstreifens von der Startkante wählbar.

Der selektive Ätzprozess wird durch HF entlang der Startkante in Gang gesetzt. Die SiO2-Opferschicht (2) wird aufgelöst und dabei wölbt sich die verspannte Doppelschicht (3) vom Substrat (1) weg und der Rollvorgang startet. In mehreren Rotationen entsteht durch den Rollvorgang eine Übergitterstruktur mit von innen nach außen abwechselnd aufeinander liegenden Silizium- und Germaniumlagen. Der entlang direkt an der Startkante aufgebrachte erste Kontaktstreifen (6) dient nun als innere Elektrode der Anordnung, während der zweite Kontaktstreifen (6) während des Aufrollvorgangs in die letzte äußere Windung der Rolle integriert wird und als äußerer Kontakt der aufgerollten Heterostruktur dient.

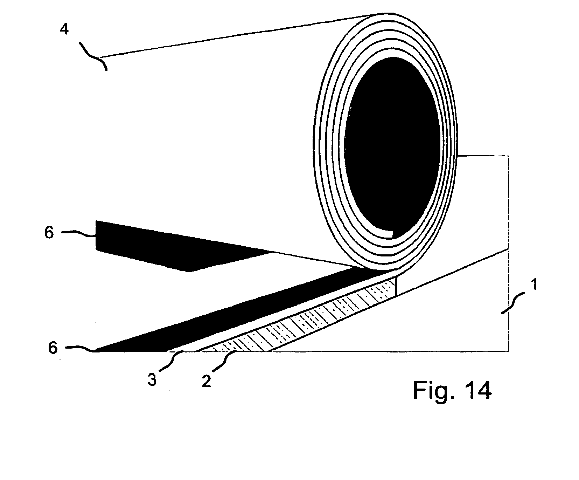

Der Temperaturgradient in der vollständig prozessierten Struktur, die in Fig. 14 gezeigt ist, bildet sich zwischen einem äußeren Wärmereservoir, das sich im Substrat befindet und einem durch den inneren Kanal der aufgerollten Heterostruktur strömenden Kühlmedium (Wasser). Das Wärmegefälle verläuft damit von außen nach innen.

### Bezugszeichenliste

- 1: Substrat
- 2: Opferschicht
- 3: Doppelschicht a. Größere Gitterkonstante b. Kleinere Gitterkonstante
- 4: Fertige Rolle aus n-dotiertem Halbleitermaterial
- 5: Fertige Rolle aus p-dotiertem Halbleitermaterial
- 6: Zuleitungen Leiterbahnen
- 7: Richtung des Wärmegefälles
- 8: Zwischenisolator (Barriereschicht)
- 9: Halbleiterschicht p-leitend
- 10: Deckisolator
- 11: Fertige Rolle aus n- und p-dotiertem Halbleitermaterial

## Patentansprüche

1. Thermoelektrisches Bauelement,
a) zur Ausnutzung des Peltier-Seebeck-basierten Wirkprinzips bestehend aus zwei oder mehreren getrennt oder gemeinsam mittels der roll-up-Technologie aufgerollten Dünnschichten (4,5), wovon je eines aus einem p- und einem n-dotierten Halbleitermaterial besteht und diese den p- und n-leitenden thermoelektrischen Schenkel bilden, und die mäanderartig miteinander über elektrische Kontakte verbunden sind, und wobei die zwei oder mehreren aufgerollten Dünnschichten auf einem elektrisch nichtleitenden Substrat (1) mit maximal 5 % ihrer gesamten Fläche mit den elektrischen Kontakten und dem Substrat (1) stoffschlüssig verbunden sind, und so die zwei oder mehr Schenkel des thermoelektrischen Bauelementes bilden
oder
b) zur Ausnutzung des thermionischen Wirkprinzipes bestehend aus einem mittels der roll-up-Technologie aufgerollten Mehrschichtaufbau (11) aus einer Dünnschicht (9) aus einem p-dotierten Halbleitermaterial, aus einer darauf aufgebrachten elektrisch nichtleitenden Barriereschicht (8), und aus einer wiederum darauf aufgebrachten Dünnschicht aus einem n-dotierten Halbleitermaterial, wobei die Abfolge der Dünnschichten (9) mit dazwischen aufgebrachten Barriereschichten (8) ein- oder mehrmals übereinander angeordnet und/oder in umgekehrter Reihenfolge der p- und n-dotierten Dünnschichten und dann insgesamt aufgerollt ist, und wobei die Dünnschichten jeweils elektrisch kontaktiert sind und keinerlei direkter stofflicher Kontakt zwischen ihnen vorhanden ist, und der gesamten aufgerollte Mehrschichtaufbau (11) auf einem elektrisch nichtleitenden Substrat (1) mit maximal 5 % seiner gesamten Fläche mit den elektrischen Kontakten und dem Substrat (1) stoffchlüssig verbunden ist.

2. Bauelement nach Anspruch 1, bei dem die mindestens zwei getrennt aufgerollten Dünnschichten (4,5) zwei Thermoelemente sind, wobei je eines aus einem p- und einem n-dotierten Halbleitermaterial besteht, und/oder bei dem eine Vielzahl von Thermoelementen vorhanden ist, die nebeneinander und die p- und n-dotierten Thermoelemente immer abwechselnd angeordnet sind und die über die elektrischen Kontakte mäanderartig miteinander verbunden sind, und/oder bei dem eine Vielzahl von Thermoelementen vorhanden ist, die übereinander und die p- und n-dotierten Thermoelemente immer abwechselnd angeordnet sind und die über die elektrischen Kontakte mäanderartig miteinander verbunden sind, und/oder bei dem die p- und n-dotierten Halbleiterschichten gemeinsam aufgerollt werden, wobei die entstehende Rolle (4,5) beide thermoelektrischen Schenkel beinhaltet, wobei die p- und n-dotierten Halbleiterschichten zur Ausbildung der mäanderartigen Kontaktierung an einem Rollenende elektrisch leitend miteinander verbunden sind.

3. Bauelement nach Anspruch 1, bei dem die aufgerollten Dünnschichten (4,5) oder der aufgerollt Mehrschichtaufbau (11) auf einem Substrat (1) angeordnet sind, wobei das Substrat (1) vorteilhafterweise aus Resten der Opferschicht (2), einer Barriere-(B) oder anderen Funktionsschicht oder aus einem Si- oder GaAs-Substrat besteht.

4. Bauelement nach Anspruch 1, bei dem das aufgerollte Dünnschichtmaterial (4,5) eine Dicke von 4 nm bis 200nm und Längen, von 0,5 µm bis 5 mm aufweist, und/oder der aufgerollte Mehrschichtaufbau (11) eine Dicke von 50 nm bis 100 nm und Längen von 0.5 µm bis 5 µm aufweist, und/oder die aufgerollten Dünnschichten (4,5) oder der aufgerollte Mehrschichtaufbau (11) eine vollständige Windung bis 20 Windungen aufweisen.

5. Bauelement nach Anspruch 1, bei dem die aufgerollten Dünnschichten (4,5) aus SiGe, FeSi₂, MnSi_{1.76,} CoSb₃, PbTe, Bi₂Te₃ bestehen, und/oder die p- und n-dotierten Schichten des Mehrschichtaufbaus (11) aus InGaAs, AlGaAs, Si, Ge, SiGe bestehen, und/oder die Barriereschicht (8) des Mehrschichtaufbaus (11) aus AlGaAs, Oxiden oder Nitriden (SiO2, SiN) besteht.

6. Bauelement nach Anspruch 1, bei dem das thermoelektrische Bauelement eine halbleitende Übergitter-Heterostruktur oder ein thermionisches Bauelement ist.

7. Bauelement nach Anspruch 1, bei dem eine Vielzahl von aufgerollten Dünnschichten (4,5) oder aufgerollten Mehrschichtaufbauten (11) vorhanden sind, die nebeneinander und übereinander angeordnet sind, und/oder die aufgerollten Dünnschichten (4,5) und der aufgerollte Mehrschichtaufbau (11) weitere Funktions- und Hilfsschichten aufweisen, wobei vorteilhafterweise als weitere Funktions- und Hilfsschichten Isolatorschichten, Rollhilfsschichten, Abdeckschichten vorhanden sind.

8. Verfahren zur Herstellung eines thermoelektrischen Bauelementes, bei dem
a) auf ein elektrisch nichtleitendes Substrat (1) elektrische Kontakte mäanderförmig aufgebracht werden, nachfolgend eine oder mehrere elektrisch nichtleitende Opferschichten (2) ganz oder teilweise auf das Substrat (1) und höchstens teilweise auf die elektrischen Kontakte aufgebracht werden, oder eine elektrisch nichtleitende Opferschicht (2), die als Substrat (1) dient, mit mäanderförmigen elektrischen Kontakten versehen wird, danach eine oder mehrere Schichten aus einem p-dotierten Halbleitermaterial mindestens auf Teile der elektrischen Kontakte und die Opferschicht (2) aufgebracht wird, dann mindestens eine weitere Opferschicht (2) aufgebracht wird, danach eine oder mehrere Schicht aus einem n-dotierten Halbleitermaterial mindestens auf Teile der elektrischen Kontakte un die Opferschicht aufgebracht wird, daran anschließend die Opferschichten (2) teilweise oder vollständig entfernt werden,
oder
b) auf ein elektrisch nichtleitendes Substrat (1) mit elektrischen Kontakten eine elektrisch nichtleitende Opferschicht aufgebracht wird, oder eine elektrisch nichtleitende Opferschicht (2), die als Substrat dient, mit elektrischen Kontakten versehen wird, darauf eine Schicht (9) aus einem p-dotierten Halbleitermaterial nachfolgend eine elektrisch nichtleitende Barriereschicht (8) und darauf eine Schicht aus einem n-dotierte Halbleitermaterial aufgebracht wird, wobei die Aufbringung der Halbleitermaterialschichten derart erfolgt, dass keinerlei direkter stofflicher Kontakt zwischen diesen Schichten oberhalb und unterhalb der Barriereschicht (8) realisiert wird, dann die Opferschicht (2) teilweise oder ganz entfernt wird,
c) und wobei die Aufbringung der Schichten für a) und b) aus dem p- oder n-dotierten Halbleitermaterial und der Barriereschichten derart erfolgt, dass in den Schichten aus dem p- oder n-dotierten Halbleitermaterial und der Barriereschichten ein Spannungsgradient vorliegt, der nach der Entfernung der Opferschicht(en) zum Aufrollen der Schicht aus einem p- und/oder n-dotierten Halbleitermaterial und der Barriereschichten führt,
d) und wobei das Aufrollen nach a) und b) so durchgeführt wird, dass die Dünnschichten (4,5) nach a) und der Mehrschichtaufbau (11) nach b) nach dem Aufrollen jeweils mit maximal 5 % ihrer gesamten Fläche mit den elektrischen Kontakten und dem Substrat (1) stoffschlüssig verbunden sind,
e) und wobei die Anordnung der aufgerollten Schichten (4,5,11) nach a) und b) aus einem p- oder n-dotierten Halbleitermaterial auch in umgekehrter Reihenfolge realisierbar ist und/oder neben- oder übereinander realisiert wird, oder beim Mehrschichtaufbau die unter b) genannte Schichtabfolge ein- oder mehrmals übereinander realisiert wird,

9. Verfahren nach Anspruch 8, bei dem als Opferschich (2) elektrisch nichtleitende, organische Opferschichtmaterialien eingesetzt werden, und/oder das Entfernen der Opferschichten durch Ätzen mit Säuren oder Laugen oder durch Lösen mit Wasser oder Lösungsmitteln durchgeführt wird, und/oder nach dem Aufbringen der Opferschicht oder Opferschichten diese strukturiert werden, wobei die Strukturierung vorteilhafterweise mittels lithografischer Verfahren realisiert wird.

10. Verfahren nach Anspruch 8, bei dem auf die elektrischen Kontakte und die Opferschicht(en) (2) eine Rollhilfsschicht und darauf dann mindestens teilweise die Schicht aus einem p- oder n-dotierten Halbleitermaterial aufgebracht wird, wobei vorteilhafterweise als Rollhilfsschicht eine Schicht aus Al₂O₃, SiO₂ oder Si₃N₄ aufgebracht wird.

11. Verfahren nach Anspruch 8, bei dem die Schichten aufgebracht werden, wobei während des Aufbringens der Schicht aus einem p- oder n-dotierten Halbleitermaterial innerhalb der Schicht ein Verspannungsgradient durch Gitterfehlanpassung ausgebildet wird.

12. Verfahren nach Anspruch 8, bei dem auf das Substrat (1) eine Opferschicht (2) teilweise aufgebracht und nachfolgend mindestens eine Schicht (9) aus einem p-dotierten Halbleitermaterial, darüber eine Schicht aus Isolatormaterial und darüber eine Schicht aus einem n-dotierten Halbleitermaterial aufgebracht wird, wobei die gegensätzlich dotierten Halbleiterschichten entlang einer Kante durch die Schicht aus einem Isolatormaterial hindurch elektrisch miteinander verbunden werden, wobei vorteilhafterweise die elektrischen Kontaktierung der beiden gegensätzlich dotierten Halbleiterschichten entlang der Kante erfolgt, die genau jener Kante gegenüber liegt, entlang der beide Halbleiterschichten bereits elektrisch miteinander verbunden sind.

13. Verfahren nach Anspruch 8, bei dem ein Substrat (1) eingesetzt wird, welches aus einem elektrisch nichtleitenden Material besteht, oder aus Resten der Opferschichten, oder aus Barriere- oder anderen Funktionsschichten besteht.

14. Verfahren nach Anspruch 8, bei dem auf alle aufgebrachten Schichten eine Schicht aus einem Isolatormaterial komplett überdeckend aufgebracht wird, so dass während des Aufrollprozesses durch Auflösen der Opferschicht keine zusätzliche elektrische Kontaktierung entsteht.

15. Verfahren nach Anspruch 8, bei dem eine oder mehrere Schichten aus einem p-dotierten Halbleitermaterial mindestens auf Teile der elektrischen Kontakte und auf eine Opferschicht (2) aufgebracht werden, dann mindestens eine elektrisch nichtleitende Barriereschicht (8) aufgebracht wird, danach eine oder mehrere Schichten aus einem n-dotierten Halbleitermaterial mindestens auf Teile der elektrischen Kontakte und die Barriereschicht (8) aufgebracht werden, und daran anschließend die p- und n-dotierten Halbleiterschichten an dem den Kontakten gegenüberliegenden Rollenende elektrisch miteinander verbunden werden, und dann die Opferschicht (2) vollständig entfernt wird.

## Claims

1. Thermoelectric component,
a) for utilization of the Peltier-Seebeck-based active principle consisting of two or more thin layers (4, 5) rolled up separately or jointly by means of roll-up technology, one of which respectively consists of a p- and an n-doped semiconductor material and these form the p- and n-conducting thermoelectric limbs, and which are connected to one another via electrical contacts in a meander-like manner, and wherein the two or more rolled-up thin layers on an electrically non-conductive substrate (1) are cohesively connected to the electrical contacts and the substrate (1) by a maximum of 5% of their total area, and thus form the two or more limbs of the thermoelectric component,
or
b) for utilization of the thermionic active principle consisting of a multilayer construction (11) rolled up by means of roll-up technology and composed of a thin layer (9) composed of a p-doped semiconductor material, an electrically non-conducting barrier layer (8) applied thereto, and a thin layer composed of an n-doped semiconductor material in turn applied thereto, wherein the sequence of the thin layers (9) with barrier layers (8) applied therebetween is arranged once or repeatedly one above another and/or with an opposite order of the p- and n-doped thin layers and is then rolled up in its entirety, and wherein the thin layers are in each case electrically contact-connected and there is no direct material contact whatsoever between them, and the entire rolled-up multilayer construction (11) on an electrically non-conductive substrate (1) is cohesively connected to the electrical contacts and the substrate (1) by a maximum of 5% of its total area.

2. Component according to Claim 1, wherein the at least two separately rolled-up thin layers (4, 5) are two thermoelements, wherein one respectively consists of a p- and an n-doped semiconductor material, and/or wherein a multiplicity of thermoelements are present which are arranged alongside one another and with the p- and n-doped thermoelements always alternating and which are connected to one another via the electrical contacts in a meander-like manner, and/or wherein a multiplicity of thermoelements are present which are arranged one above another and with the p- and n-doped thermoelements always alternating and which are connected to one another via the electrical contacts in a meander-like manner, and/or wherein the p- and n-doped semiconductor layers are rolled up jointly, wherein the resulting roll (4, 5) comprises both thermoelectric limbs, wherein the p- and n-doped semiconductor layers are electrically conductively connected to one another at one end of the roll for the purpose of forming the meander-like contact-connection.

3. Component according to Claim 1, wherein the rolled-up thin layers (4, 5) or the rolled-up multilayer construction (11) are/is arranged on a substrate (1), wherein the substrate (1) advantageously consists of residues of the sacrificial layer (2), of a barrier (8) or other functional layer or of an Si or GaAs substrate.

4. Component according to Claim 1, wherein the rolled-up thin-layer material (4, 5) has a thickness of 4 nm to 200 nm and lengths of 0.5 µm to 5 mm, and/or the rolled-up multilayer construction (11) has a thickness of 50 nm to 100 nm and lengths of 0.5 µm to 5 µm, and/or the rolled-up thin layers (4, 5) or the rolled-up multilayer construction (11) have/has one complete turn to 20 turns.

5. Component according to Claim 1, wherein the rolled-up thin layers (4, 5) consist of SiGe, FeSi₂, MnSi₁.₇₆, CoSb₃, PbTe, Bi₂Te₃, and/or the p- and n-doped layers of the multilayer construction (11) consist of InGaAs, AlGaAs, GaAs, Si, Ge, SiGe, and/or the barrier layer (8) of the multilayer construction (11) consists of AlGaAs, oxides or nitrides (Si02, SiN).

6. Component according to Claim 1, wherein the thermoelectric component is a semiconducting superlattice heterostructure or a theroionic component.

7. Component according to Claim 1, wherein a multiplicity of rolled-up thin layers (4, 5) or rolled-up multilayer constructions (11) are present, which are arranged alongside one another and one above another, and/or the rolled-up thin layers (4, 5) and the rolled-up multilayer construction (11) have further functional and auxiliary layers, wherein insulator layers, rolling auxiliary layers, covering layers are advantageously present as further functional and auxiliary layers.

8. Method for producing a thermoelectric component, wherein
a) electrical contacts are applied to an electrically non-conductive substrate (1) in a meandering fashion, afterwards one or a plurality of electrically non-conductive sacrificial layers (2) are applied wholly or partly to the substrate (1) and at most partly to the electrical contacts, or an electrically non-conductive sacrificial layer (2) serving as substrate (1) is provided with meandering electrical contacts, subsequently one or a plurality of layers composed of a p-doped semiconductor material is/are applied at least to parts of the electrical contacts and the sacrificial layer (2), then at least one further sacrificial layer (2) is applied, subsequently one or a plurality of layers composed of an n-doped semiconductor material is/are applied at least to parts of the electrical contacts and the sacrificial layer, and following that the sacrificial layers (2) are partly or completely removed,
or
b) an electrically non-conductive sacrificial layer is applied to an electrically non-conductive substrate (1) with electrical contacts, or an electrically non-conductive sacrificial layer (2) serving as substrate is provided with electrical contacts, a layer (9) composed of a p-doped semiconductor material is applied thereto afterwards an electrically non-conductive barrier layer (8) is applied and a layer composed of an n-doped semiconductor material is applied thereto, wherein the semiconductor material layers are applied in such a way that no direct material contact whatsoever between these layers above and below the barrier layer (8) is realized, then the sacrificial layer (2) is partly or wholly removed,
c) and wherein the application of the layers for a) and b) composed of the p- or n-doped semiconductor material and the barrier layers is effected in such a way that, in the layers composed of the p- or n-doped semiconductor material and the barrier layers, a stress gradient is present which, after the removal of the sacrificial layer(s), leads to the roll-up of the layer composed of a p- and/or n-doped semiconductor material and the barrier layers,
d) and wherein the roll-up according to a) and b) is carried out such that the thin layers (4, 5) according to a) and the multilayer construction (11) according to b), after the roll-up, are cohesively connected to the electrical contacts and the substrate (1) in each case by a maximum of 5% of their total area,
e) and wherein the arrangement of the rolled-up layers (4, 5, 11) according to a) and b) composed of a p- or n-doped semiconductor material can also be realized in the opposite order and/or is realized alongside one another or one above another, or, in the case of the multilayer construction, the layer sequence mentioned under b) is realized once or repeatedly one above another.

9. Method according to Claim 8, wherein electrically non-conductive, organic sacrificial layer materials are used as the sacrificial layer (2) and/or the removal of the sacrificial layers is carried out by etching using acids or alkaline solutions or by dissolving using water or solvents, and/or after the application of the sacrificial layer or sacrificial layers the latter are patterned, wherein the patterning is advantageously realized by means of lithographic methods.

10. Method according to Claim 8, wherein a rolling auxiliary layer is applied to the electrical contacts and the sacrificial layer(s) (2) and then at least partly the layer composed of a p- or n-doped semiconductor material is applied thereto, wherein a layer composed of Al₂O₃, SiO₂ or Si₃N₄ is advantageously applied as the rolling auxiliary layer.

11. Method according to Claim 8, wherein the layers are applied, wherein, during the application of the layer composed of a p- or n-doped semiconductor material, a strain gradient is formed within the layer by lattice mismatch.

12. Method according to Claim 8, wherein a sacrificial layer (2) is partly applied to the substrate (1) and afterwards at least one layer (9) composed of a p-doped semiconductor material is applied, a layer composed of insulator material is applied thereabove and a layer composed of an n-doped semiconductor material is applied thereabove, wherein the oppositely doped semiconductor layers are electrically connected to one another along an edge through the layer composed of an insulator material, wherein the electrical contact-connection of the two oppositely doped semiconductor layers is advantageously effected along the edge situated opposite exactly that edge along which the two semiconductor layers are already electrically connected to one another.

13. Method according to Claim 8, wherein a substrate (1) is used which consists of an electrically non-conductive material, or consists of residues of the sacrificial layers, or consists barrier or other functional layers.

14. Method according to Claim 8, wherein a layer composed of an insulator material is applied to all the applied layers in a completely covering fashion, such that no additional electrical contact-connection arises during the roll-up process as a result of the sacrificial layer being dissolved.

15. Method according to Claim 8, wherein one or a plurality of layers composed of a p-doped semiconductor material are applied at least to parts of the electrical contacts and to a sacrificial layer (2), then at least one electrically non-conductive barrier layer (8) is applied, subsequently one or a plurality of layers composed of an n-doped semiconductor material are applied at least to parts of the electrical contacts and the barrier layer (8), and following that the p- and n-doped semiconductor layers are electrically connected to one another at the end of the roll situated opposite the contacts, and then the sacrificial layer (2) is completely removed.

## Revendications

1. Composant thermoélectrique
a) utilisant le principe de Peltier-Seebeck, constitué de deux ou plusieurs couches minces (4, 5) enroulées séparément ou conjointement au moyen de la technologie d'enroulement, chacune étant constituée respectivement d'un matériau semi-conducteur à dopage p et d'un matériau semi-conducteur à dopage n qui forment respectivement la branche thermoélectrique à conduction n et la branche thermoélectrique à conduction p et qui sont reliées les uns aux autres en méandres par des contacts électriques, les deux ou plusieurs couches minces enroulées étant reliées en correspondance de matière aux contacts électriques et au substrat (1) sur un substrat électriquement non conducteur (1) par au moins 5 % de leur surface totale et formant ainsi les deux ou plusieurs branches du composant thermoélectrique ou
b) utilisant le principe thermo-ionique, constitué d'une structure multicouche (11) enroulée au moyen de la technologie d'enroulement, la structure étant constituée d'une couche mince (9) de matériau semi-conducteur à dopage p sur laquelle est appliquée une couche de barrière (8) électriquement non conductrice, elle-même surmontée une autre couche mince de matériau semi-conducteur à dopage n, la succession des couches minces (9) entre lesquelles sont disposées des couches de barrière (8) étant empilée une ou plusieurs fois et/ou en succession inverse des couches minces à dopage p et des couches minces à dopage n avant d'être enroulées, les couches minces étant toutes en contact électrique et aucun contact matériel direct étant prévu entre elles, l'ensemble de la structure multicouche (11) enroulée étant relié en correspondance de matière aux contacts électrique et au substrat (1) sur un substrat électriquement non conducteur (1) par au moins 5 % de sa surface totale.

2. Composant selon la revendication 1, dans lequel les deux ou plusieurs couches minces (4, 5) enroulées séparément sont deux thermoéléments, chacun constitué d'un matériau semi-conducteur à dopage p et d'un matériau semi-conducteur à dopage n,
et/ou plusieurs thermoéléments sont disposés les uns à côté des autres, les thermoéléments à dopage p et les thermoéléments à dopage n étant toujours alternés et étant reliés les uns aux autres en méandres par les contacts électriques,
et/ou plusieurs thermoéléments sont disposés les uns au-dessus des autres, les thermoéléments à dopage p et les thermoéléments à dopage n étant toujours alternés et reliés les uns aux autres en méandres par l'intermédiaire des contacts électriques,
et/ou les couches semi-conductrices à dopage p et les couches semi-conductrices à dopage n sont enroulées ensemble, le rouleau (4, 5) ainsi formé contenant les deux branches thermoélectriques, les couches semi-conductrices à dopage p et les couches semi-conductrice à dopage n étant reliées électriquement les unes aux autres à une extrémité du rouleau pour former les contacts en méandres.

3. Composant selon la revendication 1, dans lequel les couches minces (4, 5) enroulées ou la structure multicouche (11) enroulée sont disposées sur un substrat (1), le substrat (1) étant avantageusement constitué de restes de la couche sacrifiée (2), d'une couche de barrière (8), d'une autre couche fonctionnelle ou d'un substrat de Si ou de GaAs.

4. Composant selon la revendication 1, dans lequel le matériau en couche mince enroulé (4, 5) présente une épaisseur de 4 nm à 200 nm et une longueur de 0,5 µm à 5 mm et/ou dans lequel la structure multicouche enroulée (11) présente une épaisseur de 50 nm à 100 nm et une longueur de 0,5 µm à 5 µm, et/ou les couches minces (4, 5) enroulées ou la structure multicouche (11) enroulée présentent entre un tour complet et 20 tours.

5. Composant selon la revendication 1, dans lequel les couches minces (4, 5) enroulées sont constituées de SiGe, FeSi₂, MnSi₁,₇₆, CoSb₃, PbTe, Bi₂Te₃ et/ou les couches à dopage p et les couches à dopage n de la structure multicouche (11) sont constituées d'InGaAs, d'AlGaAs, de GaAs, de Si, de Ge ou de SiGe, et/ou la couche de barrière (8) de la structure multicouche (11) est constituée d'AlGaAs, d'oxyde ou de nitrure (SiO₂, SiN).

6. Composant selon la revendication 1, dans lequel le composant thermoélectrique est une hétérostructure semi-conductrice à méta-réseau ou un composant thermo-ionique.

7. Composant selon la revendication 1, dans lequel plusieurs couches minces (4, 5) enroulées ou structures multicouches (11) enroulées sont disposées les unes à côté des autres ou les unes au-dessus des autres, et/ou dans lequel les couches minces (4, 5) enroulées et la structure multicouche (11) enroulée présentent d'autres couches fonctionnelles et couches auxiliaires, des couches d'isolant, des couches auxiliaires d'enroulement ou des couches de recouvrement étant avantageusement prévues comme autres couches fonctionnelles ou couches auxiliaires.

8. Procédé de fabrication d'un composant thermoélectrique, dans lequel :
a) des contacts électriques sont placés en méandres sur un substrat (1) électriquement non conducteur, une ou plusieurs couches sacrifiées (2) électriquement non conductrices sont appliquées sur la totalité ou des parties du substrat (1) et au plus sur une partie des contacts électriques, ou une couche sacrifiée (2) électriquement non conductrice qui sert de substrat (1) est dotée de contacts électriques en méandres, une ou plusieurs couches de matériau semi-conducteur à dopage p sont appliquées au moins sur des parties des contacts électriques et la couche sacrifiée (2) est appliquée, au moins une autre couche sacrifiée (2) est appliquée, ensuite une ou plusieurs couches de matériau semi-conducteur à dopage p sont appliquées au moins sur une partie des contacts électriques et la couche sacrifiée est appliquée, les couches sacrifiées (2) étant ensuite enlevées partiellement ou complètement,
ou
b) une couche sacrifiée électriquement non conductrice est déposée sur un substrat électriquement non conducteur (1) doté de contacts électriques ou une couche sacrifiée électriquement non conductrice (2) qui sert de substrat est dotée de contacts électriques, une couche (2) de matériau semi-conducteur à dopage p est appliquée, ensuite une couche de barrière électriquement non conductrice (8) est appliquée et une couche de matériau semi-conducteur à dopage n est appliquée par dessus, l'application des couches de matériau semi-conducteur s'effectuant de telle sorte qu'il n'y ait aucun contact matériel direct entre ces couches au-dessus et en dessous de la couche de barrière (8), la couche sacrifiée (2) étant ensuite enlevée partiellement ou totalement,
c) l'application des couches a) et b) de matériau semi-conducteur à dopage p ou de matériau semi-conducteur à dopage n et des couches de barrière s'effectuant de manière à obtenir un gradient de tension dans les couches de matériau semi-conducteur à dopage p ou de matériau semi-conducteur à dopage n et les couches de barrière, ce gradient de tension entraînant après l'enlèvement de la ou des couches sacrifiées l'enroulement de la couche de matériau semi-conducteur à dopage p et/ou de la couche de matériau semi-conducteur à dopage n et des couches de barrière,
d) après a) et b), l'enroulement étant réalisé de telle sorte qu'après l'enroulement, les couches minces (4, 5) de a) et la structure multicouche (11) de b) soient reliées en correspondance de matière aux contacts électriques et au substrat (1), chacune par au plus 5 % de sa surface totale,
e) l'agencement des couches (4, 5, 11) enroulées de a) et b) de matériau semi-conducteur à dopage p ou de matériau semi-conducteur à dopage n pouvant également être réalisé dans la succession inverse et/ou est réalisé en les plaçant les unes à côté des autres ou les unes au-dessus des autres, ou, dans le cas de la structure multicouche, la succession de couches citée en b) étant réalisée en les superposant une ou plusieurs fois.

9. Procédé selon la revendication 8, qui utilise comme couche sacrifiée (2) des matériaux organiques électriquement non conducteurs de couche sacrifiée, et/ou l'enlèvement des couches sacrifiées est réalisé par gravure à l'acide ou aux bases ou par dissolution dans l'eau ou dans des solvants, et/ou ces couches de barrière sont structurées après l'application de la couche de barrière ou des couches de barrière, la structuration étant avantageusement réalisée par une opération lithographique.

10. Procédé selon la revendication 8, dans lequel une couche d'aide à l'enroulement est appliquée sur les contacts électriques et une couche d'aide à l'enroulement est appliquée sur la ou les couches de barrière (2), avec par dessus au moins une partie de la couche de matériau semi-conducteur à dopage p ou de matériau semi-conducteur à dopage n, une couche en Al₂O₃ SiO₂ ou Si₃N₄ étant avantageusement appliquée comme couché d'aide à l'enroulement.

11. Procédé selon la revendication 8, dans lequel les couches sont appliquées et dans lequel par application de la couche de matériau semi-conducteur à dopage p ou de matériau semi-conducteur à dopage n, un gradient de tension est formé à l'intérieur de la couche par adaptation des défauts de réseau.

12. Procédé selon la revendication 8, dans lequel une couche sacrifiée (2) est appliquée sur une partie du substrat (1) et ensuite au moins une couche (9) de matériau semi-conducteur à dopage p est appliquée, une couche de matériau isolant est ensuite appliquée, une couche de matériau semi-conducteur à dopage n est appliquée par dessus, les couches semi-conductrices à dopage opposé étant reliées électriquement les unes aux autres le long d'un bord à travers la couche de matériau isolant, la mise en contact électrique des deux couches semi-conductrices à dopage opposé s'effectuant avantageusement le long du bord exactement opposé au bord le long duquel les deux couches semi-conductrices ont déjà été reliées électriquement l'une à l'autre.

13. Procédé selon la revendication 8, qui utilise un substrat (1) constitué d'un matériau électriquement non conducteur, des couches sacrifiées, des couches de barrière ou d'autres couches fonctionnelles.

14. Procédé selon la revendication 8, dans lequel une couche de matériau isolant est appliquée de manière à recouvrir complètement toutes les couches appliquées, de telle sorte qu'aucun contact électrique supplémentaire ne soit formé par détachement de la couche sacrifiée pendant l'opération d'enroulement.

15. Procédé selon la revendication 8, dans lequel une ou plusieurs couches de matériau semi-conducteur à dopage p sont appliquées au moins sur des parties des contacts électriques et sur une couche sacrifiée (2), au moins une couche de barrière électriquement non conductrice (8) est ensuite appliquée, une ou plusieurs couches de matériau semi-conducteur à dopage n sont ensuite appliquées au moins sur des parties des contacts électriques et sur la couche de barrière (8), les couches semi-conductrices à dopage p et les couches semi-conductrices à dopage n étant ensuite reliées électriquement les unes aux autres aux extrémités du rouleau situées face aux contacts, la couche sacrifiée (2) étant ensuite complètement enlevée.
